# EUROPEAN PATENT APPLICATION

(11) **EP 1 811 646 A1**
(43) Date of publication of application: **25.07.2007**
(21) Application number: 05799025.1
(22) Date of filing: 26.10.2005
(51) Int. Cl.: H02N 11/00, H01L 35/30

(54) **THERMOELECTRIC GENERATION DEVICE**

(30) Priority: 27.10.2004 JP 2004311963; 01.11.2004 JP 2004317731
(71) Applicant: Hino Motors, Ltd., Hino-shi, Tokyo 191-8660 (JP)
(72) Inventor: MACHIDA, Koichi, Hino-shi Tokyo 1918660 (JP)
(74) Representative: Köhler, Walter
(86) International application number: PCT/JP2005/019665
(87) International publication number: WO 2006/046590

(57) **Abstract**

Prevented is thermoelectric elements from being exposed to abnormally high temperature.

A thermoelectric generating device has a thermoelectric module 12 with p- and n-type thermoelectric elements 1 and 2 being connected in series, a passage 7 through which heating fluid 8 flows to heat one side of the module and a passage 10 through which cooling fluid 11 flows to cool the other side of the module 12; arranged between the passage 7 and one side of the thermoelectric module 12 is a passage 15 through which urgently cooling fluid 25 flows for prevention of the thermoelectric elements 1 and 2 from abnormally high temperature.

## Description

### Technical Field

The invention relates to a thermoelectric generating device.

### Background Art

A thermoelectric generating device in general is a system in which p- and n-type thermoelectric elements are connected electrically in series through an electrode plate and are heated and cooled at their one and the other ends, respectively, so that potential difference is generated due to temperature difference caused in the thermoelectric elements. A phenomenon of causing such potential difference is known as Seebeck effect.

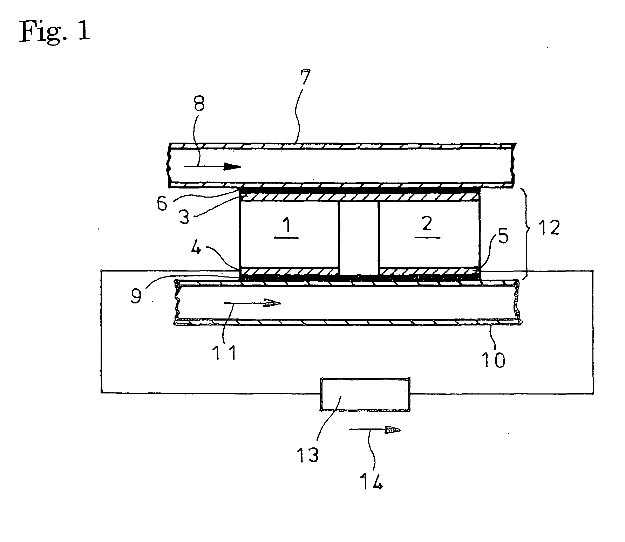

An example of conventional thermoelectric generating devices using Seebeck effect is shown in Fig. 1 where reference numeral 1 and 2 respectively denote p- and n-type thermoelectric elements arranged in parallel with each other; 3, an electrode plate connected to one ends of the elements 1 and 2 for connection of them; and 4 and 5, electrode plates connected to the other ends of the elements 1 and 2, respectively. The thermoelectric elements 1 and 2 are made of, for example, Bi-Te-series material; the electrode plates 3, 4 and 5, highly thermal and electric conductive material such as cupper alloy.

Reference numeral 6 designates an insulating member fixed to an outer surface of the electrode plate 3; 7, a passage which is fixed to an outer surface of the member 6 and through which heating fluid 8 flows; 9, an insulating member fixed to outer surfaces of the electrode plates 4 and 5; and 10, a passage which is fixed to an outer surface of the member 9 and through which cooling fluid 11 flows. The insulating members 6 and 9 are made of, for example, ceramic such as alumina or aluminum nitride.

Thus, the p- and n-type thermoelectric elements 1 and 2, electrode plates 3, 4 and 5 and insulating members 6 and 9 provide a thermoelectric module 12.

An electric series circuit for the p- and n-type thermoelectric elements 1 and 2 is electrically connected at its base and terminal ends with a load 13, electric current 14 being adapted to flow in a direction of arrow.

In the thermoelectric generating device shown in Fig. 1, passed through the passage 7 in a direction of arrow is heating fluid 8 such as vehicle exhaust gas; and passed through the passage 10 in a direction of arrow is cooling fluid 11 such as water. Thus, ends of the thermoelectric elements 1 and 2 on the plate 3 (one side of the module 12) are heated while ends of the elements 1 and 2 on the plates 4 and 5 (the other side of the module 12) are cooled, so that potential difference is caused between the opposite ends of the elements 1 and 2 due to temperature difference. The electric current 14 generated by the potential difference is fed to the load 13 or storage means.

An example of prior art documents on thermoelectric generating devices utilizing Seebeck effect is Reference 1 which discloses a thermoelectric generating module with p-and n-type thermoelectric elements electrically connected in series and with potential difference caused due to heating and cooling of their one and the other ends, respectively.
[Reference 1] JP 9-199764A

### Summary of the Invention

### Problems to be Solved by the Invention

When elevated in temperature above a predetermined temperature, thermoelectric elements in general are changed in physical properties and are deteriorated in performances. The thermoelectric elements once changed in physical properties do not return to their original states even if they are cooled. In the thermoelectric generating device shown in Fig. 1, the insulating members 6 and 9 arranged via the electrode plates 3 and 4 on the opposite side surfaces of the thermoelectric elements 1 and 2 have no additional function of protecting the elements 1 and 2 from abnormally high temperature. Thus, when exposed to abnormally high temperature from any cause, the thermoelectric elements 1 and 2 may be disadvantageously changed in physical properties into deterioration.

In the thermoelectric generating device shown in Reference 1, support members are arranged on opposite ends of p- and n-type thermoelectric elements arranged in parallel with each other; however, the thermoelectric elements may be disadvantageously changed in physical properties into deterioration just like the case of Fig. 1 when exposed to abnormally high temperature.

The invention was made in view of the above and has its object to provide a thermoelectric generating device which can prevent thermoelectric elements from being exposed to abnormally high temperature when high-temperature gas such as vehicle exhaust gas is fed as heating fluid so as to generate electricity by a thermoelectric module.

### Means or Measures for Solving the Problems

The invention provides
a thermoelectric generating device with a thermoelectric module having p- and n-type thermoelectric elements electrically connected in series, a first passage through which heating fluid flows so as to heat one side of the module and a second passage through which cooling fluid flows so as to cool the other side of the thermoelectric module,
said thermoelectric generating device comprising a third passage arranged between said first passage and said one side of the thermoelectric module, said third passage being charged with fluidal heat mover during a normal operation and having urgently cooling fluid injected when the heating fluid in the first passage reaches or exceeds a predetermined temperature.

The thermoelectric generating device may be constituted such that,
the fluidal heat mover in the third passage is discharged and the urgently cooling fluid is injected into the third passage when heating fluid in the first passage is at or above the predetermined temperature for a predetermined duration, and that the urgently cooling fluid in the third passage is discharged and the fluidal heat mover is injected into the third passage when the urgently cooling fluid having been injected is at or below a predetermined temperature, providing the heating fluid is below a predetermined temperature for a predetermined duration.

The invention further provides
a thermoelectric generating device with a thermoelectric module having p- and n-type thermoelectric elements connected electrically in series, a first passage through which heating fluid flows so as to heat one side of the module and a second passage through which cooling fluid flows so as to cool the other side of the module,
said thermoelectric generating device comprising a third passage arranged between said first passage and said one side of the module, said third passage being charged with fluidal heat mover during a normal operation and having urgently cooling fluid injected when the fluidal heat mover reaches or exceeds a predetermined temperature.

The thermoelectric generating device may be constituted such that,
the fluidal heat mover in the third passage is discharged and the urgently cooling fluid is injected into the third passage when the fluidal heat mover in the third passage is at or above the predetermined temperature for a predetermined duration and that the urgently cooling fluid in the third passage is discharged and the fluidal heat mover is injected into the third passage when the urgently cooling fluid having been injected is at or below a predetermined temperature for a predetermined duration.

The invention still further provides
a thermoelectric generation device with a thermoelectric module having p- and n-type thermoelectric elements connected electrically in series, a first passage through which heating fluid flows so as to heat one side of the module and a second passage through which cooling fluid flows so as to cool the other side of the module,
said thermoelectric generating device comprising a third passage arranged between said first passage and said one side of the module, said third passage being charged with fluidal heat mover during a normal operation and having urgently cooling fluid injected when the thermoelectric element reaches or exceeds a predetermined temperature.

The thermoelectric generating device may be constituted such that,
the fluidal heat mover in the third passage is discharged and the urgently cooling fluid is injected into the third passage when the thermoelectric element is at or above the predetermined temperature for a predetermined duration and that the urgently cooling fluid in the third passage is discharged and the fluidal heat mover is injected into the third passage when the thermoelectric element is at or below the predetermined temperature for a predetermined duration.

The invention still further provides
a thermoelectric generating device with a thermoelectric module having p- and n-type thermoelectric elements connected electrically in series, a first passage through which heating fluid flows so as to heat one side of the module and a second passage through which cooling fluid flows so as to cool the other side of the module,
said thermoelectric generating device comprising a bypass passage connected via valve means to the first passage upstream of the thermoelectric module.

The thermoelectric generating device may further comprise
a temperature sensor for detecting temperature of the thermoelectric element or temperature in the first passage downstream of the valve means and
a controller which outputs changeover command to said valve means so as to feed the heating fluid to the bypass passage when the temperature detected by said sensor is above a predetermined value for a predetermined duration,
said controller outputting changeover command to said valve means so as to feed the heating fluid to the first passage when the temperature detected by the sensor is lower than a predetermined value for a predetermined duration.

The invention still further provides
a thermoelectric generating device with a thermoelectric module having p- and n-type thermoelectric elements connected electrically in series, a first passage through which heating fluid flows so as to heat one side of the module and a second passage through which cooling fluid flows so as to cool the other side of the module, said thermoelectric generating device comprising a bypass passage with one end connected through first valve means to said first passage upstream of the module,
said bypass passage having the other end connected via second valve means to said first passage downstream of the module.

The thermoelectric generating device may further comprise
a temperature sensor for detecting temperature of the thermoelectric element or temperature in the first passage between the first and second valve means and
a controller which outputs changeover command to said first valve means for changeover thereof so as to feed the heating fluid to the bypass passage, and outputs changeover command to said second valve means for changeover thereof so as to feed the heating fluid having been passed through the bypass passage to the first passage downstream of the module when the temperature detected by the sensor is above a predetermined value for a predetermined duration,
said controller outputting changeover command to said first valve means for changeover thereof so as to feed the heating fluid to said first passage, and outputting changeover command to said second valve means for changeover thereof so as to feed the heating fluid having been passed through said first passage to downstream of the second valve means when the temperature detected by the sensor is lower than a predetermined value for a predetermined duration.

The invention still further provides
a thermoelectric generating device with a thermoelectric module having p- and n-type thermoelectric elements connected electrically in series, a first passage through which heating fluid flows so as to heat one side of the module and s second passage through which cooling fluid flows so as to cool the other side of the module,
said thermoelectric generating device comprising a bypass passage connected via a first valve means to the first passage upstream of the module and
a third passage connected to said first passage downstream of the first valve means and upstream of the module so as to feed urgently cooling fluid to the first passage via said second valve means.

In the thermoelectric generating device, a downstream end of the bypass passage may be connected to the first passage downstream of the module.

The thermoelectric generating device may further comprise
a temperature sensor for detecting temperature of the thermoelectric element or temperature in the first passage and
a controller which output changeover commands to said first valve means for changeover thereof so as to feed the heating fluid to the bypass passage, and outputs changeover command to said second valve means for changeover thereof so as to feed the urgently cooling fluid having been passed through the third passage to said first passage when the temperature detected by the sensor is above a predetermined value for a predetermined duration,
said controller outputting changeover command to said first valve means for changeover thereof so as to feed the heating fluid to the first passage and outputting changeover command to said second valve means for changeover thereof so as to feed the heating fluid having been passed through said first valve means and through said first passage to downstream of the second valve means and so as not to feed the urgently cooling fluid to the first passage when the temperature detected by the sensor is lower than a predetermined value for a predetermined duration.

The invention still further provides
a thermoelectric generating device with a thermoelectric module having p- and n-type thermoelectric elements connected electrically in series, a first passage through which heating fluid flows so as to heat one side of the module and a second passage through which cooling fluid flows so as to cool the other side of the module,
said thermoelectric generating device comprising a third passage connected via valve means to the first passage upstream of the module so as to feed the urgently cooling fluid to the first passage.

The thermoelectric generating device may further comprise
a temperature sensor for detecting temperature of the thermoelectric element or temperature in the first passage downstream of the valve means and
a controller which outputs changeover command to said valve means for changeover thereof so as to feed the heating fluid and urgently cooling fluid to the first passage when the temperature detected by the sensor is above a predetermined value for a predetermined duration,
said controller outputting changeover command to said valve means for changeover thereof so as to feed the heating fluid to the first passage and so as not to feed the urgently cooling fluid to the first passage when the temperature detected by the sensor is lower than a predetermined value for a predetermined duration.

### Effects of the Invention

According to a thermoelectric generating device of the invention, thermoelectric elements are not exposed to abnormally high temperature so that deterioration is prevented to satisfactorily retain performances; when the heating fluid is for example vehicle exhaust gas, exhaust heat can be effectively recovered. When urgently cooling fluid is fed to first passage so as to forcibly cool the thermoelectric module, the performances of the thermoelectric elements can be further satisfactorily retained.

### Brief Description of the Drawings

[Fig. 1] A sectional view showing a conventional thermoelectric generating device.
[Fig. 2] A sectional view showing a thermoelectric generating device according to a first embodiment of the invention.
[Fig. 3] A first half of a flowchart on control for preventing thermoelectric elements from being exposed to abnormally high temperature in the thermoelectric generating device of Fig. 2.
[Fig. 4] A second half of the flowchart on control for preventing the thermoelectric elements from being exposed to abnormally high temperature in the thermoelectric generating device of Fig. 2.
[Fig. 5] A sectional view showing a thermoelectric generating device according to a second embodiment of the invention.
[Fig. 6] A first half of a flowchart on control for preventing thermoelectric elements from being exposed to abnormally high temperature in the thermoelectric generating device of Fig. 5.
[Fig. 7] A second half of the flowchart on control for preventing the thermoelectric elements from being exposed to abnormally high temperature in the thermoelectric generating device of Fig. 5.
[Fig. 8] A sectional view showing a thermoelectric generating device according to a third embodiment of the invention.
[Fig. 9] A first half of a flowchart on control for preventing thermoelectric elements from being exposed to abnormally high temperature in the thermoelectric generating device of Fig. 8.
[Fig. 10] A second half of the flowchart on control for preventing the thermoelectric elements from being exposed to abnormally high temperature in the thermoelectric generating device of Fig. 8.
[Fig. 11] A schematic diagram showing a thermoelectric generating device according to a fourth embodiment of the invention.
[Fig. 12] A sectional view of a thermoelectric module applied to the thermoelectric generating device of Fig. 11.
[Fig. 13] A flowchart for the thermoelectric generating device of Fig. 11.
[Fig. 14] A schematic diagram showing a thermoelectric generating device according to a fifth embodiment of the invention.
[Fig. 15] A first half of a flowchart for the thermoelectric generating device of Fig. 14.
[Fig. 16] A second half of the flowchart for the thermoelectric generating device of Fig. 14.
[Fig. 17] A schematic diagram of a thermoelectric generating device according to a sixth embodiment of the invention.
[Fig. 18] A first half of a flowchart for the thermoelectric generating device of Fig. 17.
[Fig. 19] A second half of the flowchart for the thermoelectric generating device of Fig. 17.
[Fig. 20] A schematic diagram of a thermoelectric generating device according to a seventh embodiment of the invention.
[Fig. 21] A schematic diagram of a thermoelectric generating device according to an eighth embodiment of the invention.
[Fig. 22] A flowchart for the thermoelectric generating device of Fig. 21.

### Explanation of the Reference Numerals

- 1: p-type thermoelectric element
- 2: n-type thermoelectric element
- 7: passage (first passage)
- 8: heating fluid
- 10: passage (second passage)
- 11: cooling fluid
- 12: thermoelectric module
- 15: passage (third passage)
- 25: urgently cooling fluid
- 26: fluidal heat mover
- 31: changeover valve (valve means)(first valve means)
- 32: passage
- 33: bypass passage
- 34: temperature sensor
- 35: controller
- 36: changeover valve (second valve means)
- 37: passage
- 38: changeover valve (second valve means)
- 39: urgently cooling fluid
- 40: passage (third passage)
- 41: changeover valve (valve means)
- V11: valve changeover command
- V12: valve changeover command
- V13: valve changeover command
- V14: valve changeover command

### Best Mode for Carrying Out the Invention

Embodiments of the invention will be described in conjunction with the drawings.

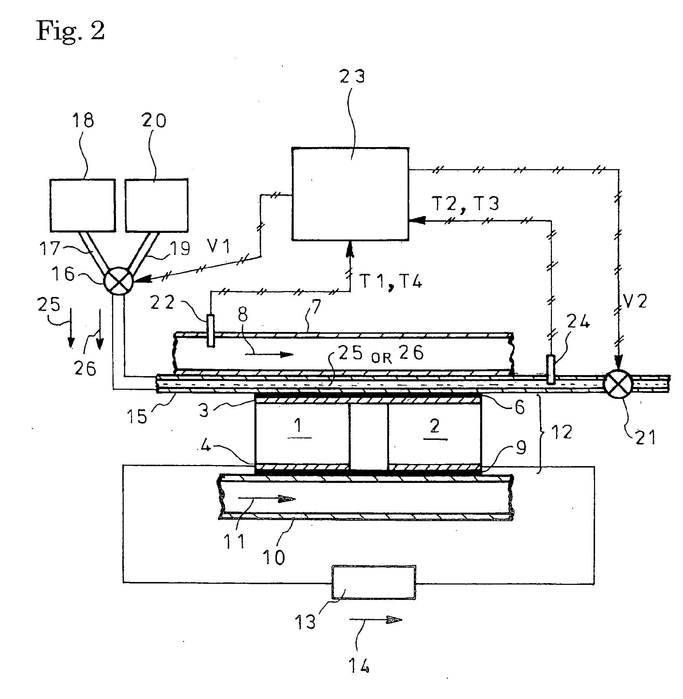

Figs. 2-4 show a first embodiment of the invention.
In the figures, parts identical to those in Fig. 1 are represented by the same reference characters. A fundamental structure is similar to that shown in Fig. 1. The embodiment is characteristic as shown in Fig. 2 that a passage 15 is arranged between an insulating member 6 and a passage 7 through which heating fluid 8 flows, in such a manner that the passage 15 closely contacts outer surfaces of the member 6 and passage 7. The passage 15 is filled with fluidal heat mover (e.g., rapeseed oil) during a normal operation; urgently cooling fluid such as water may be injected into the passage 15 in case of urgency such as abnormally high temperature.

Incorporated in the passage 15 upstream of a thermoelectric module 12 is an injection changeover valve 16 which are connected with an urgently cooling fluid bath 18 and with a fluidal heat mover bath 20 via passages 17 and 19, respectively. Incorporated in the passage 15 downstream of the module 12 is a closure valve 21.

Incorporated in the passage 7 and somewhat upstream of the module 12 is a temperature sensor 22 which detects temperature of the heating fluid 8 in the passage 7, temperatures T1 and T4 of the heating fluid detected by the sensor 22 being adapted to be sent to a controller 23. Incorporated in the passage 15 downstream of the module 12 and upstream of the valve 21 is a temperature sensor 24, temperatures T2 and T3 of the urgently cooling fluid detected by the sensor 24 being adapted to be sent to the controller 23.

The controller 23 is adapted to send valve changeover and opening/closing commands V1 and V2 to the valves 16 and 21, respectively. In Fig. 2, reference numeral 25 designates urgently cooling fluid such as water; and 26, fluidal heat mover.

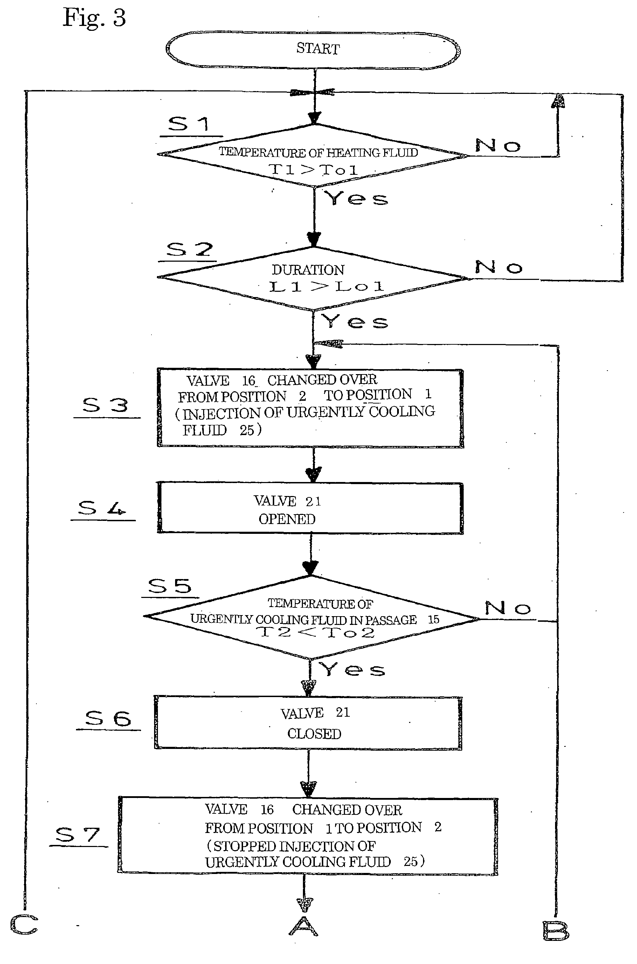

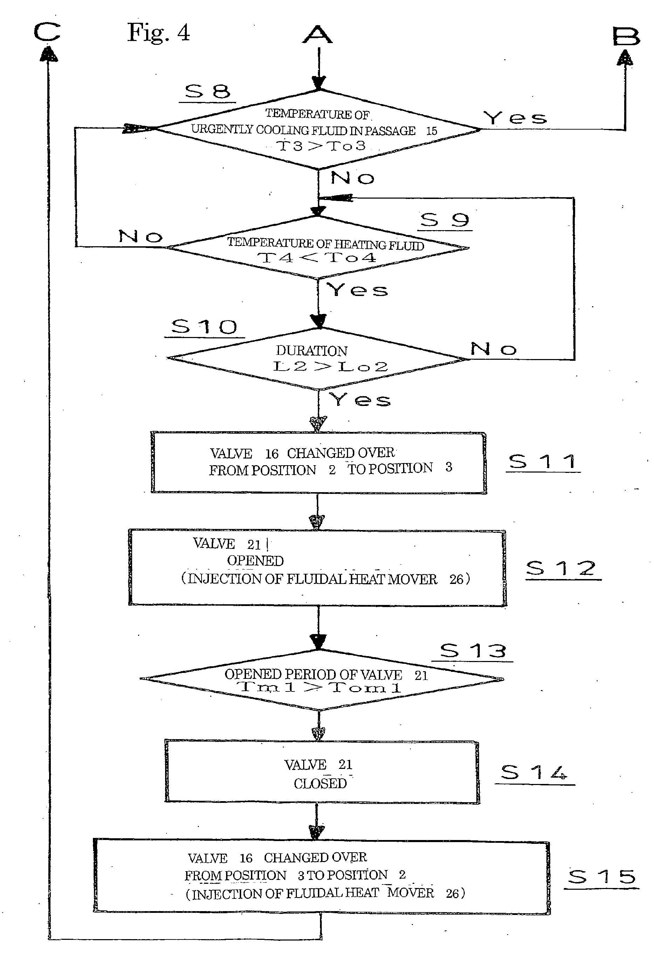

Next, mode of operation of the above embodiment will be described also in view of a flowchart shown in Figs. 3 and 4. In Figs. 3 and 4, A, B and C represent flow connections. In Figs. 3 and 4, position 1 represents a status where the valve 16 has been changed over so as to inject the urgently cooling fluid 25 from the bath 18 into the passage 15; position 2, a status where the valve 16 is closed so as not to inject the urgently cooling fluid 25 nor fluidal heat mover 26 from the bathes 18 and 20 into the passage 15; and position 3, a status where the valve 16 has been changed over so as to inject the fluidal heat mover 26 from the bath 20 into the passage 15.

During a normal operation of the thermoelectric generating device of the embodiment, the valves 16 and 21 in the passage 15 are closed, the passage 15 downstream of the valve 16 and upstream of the valve 21 being charged with fluidal heat mover 26 injected. Heating fluid 8 such as vehicle exhaust gas is fed through the passage 7 in a direction of arrow while and cooling fluid 11 such as water is fed through the passage 10 in a direction of arrow.

As a result, ends of the p- and n-type thermoelectric elements 1 and 2 on the electrode plate 3 (one side of the module 12) are heated by the fluidal heat mover 26 in the passage 15 while ends of the elements 1 and 2 on the electrode plates 4 and 5 (the other side of the module 12) are cooled, so that potential difference is generated at the opposite ends of the elements 1 and 2 due to temperature difference. Electric current 14 thus generated by the potential difference is fed to a load 13.

In the embodiment, temperatures of the heating fluid 8 and urgently cooling fluid 25 in the passage 15 are detected for control to prevent the elements 1 and 2 from being exposed to abnormally high temperature. More specifically, during the operation, temperature T1 of the heating fluid 8 fed through the passage 7 is detected by the sensor 22 and is sent to the controller 23.

In the controller 23, the temperature T1 is compared with a preset upper limit To1 of the heating fluid preset in the controller 23 (S1); when the temperature T1 is higher than the preset upper limit To1 (T1 > To1), a duration L1 thereof is detected by a timer in the controller 23. The detected duration L1 is compared with a preset duration Lo1 in the controller 23 (S2); when the duration L1 is greater than the preset duration Lo1 (L1 > Lo1), the valve changeover command V1 is sent from the controller 23 to the valve 16.

As a result, the valve 16 is changed over from position 2 to position 1, which causes the passage 17 to communicate with the passage 15, the urgently cooling fluid 25 from the bath 18 being passed through the passage 17 and valve 16 and being injected into the passage 15 (S3). As the valve 16 is changed over from position 2 to position 1, the valve 21 is opened by the opening/closing command V2 from the controller 23 (S4). As a result, the fluidal heat mover 26 having been retained in the passage 15 is urged by the fluid 25 and discharged out downstream of the valve 21. During the valve 21 being opened, the urgently cooling fluid 25 is also discharged out downstream of the valve 21.

Temperature T2 of the urgently cooling fluid 25 injected into the passage 15 is detected by the sensor 24 and is sent to the controller 23 where the detected temperature T2 is compared with a preset temperature value To2 of the urgently cooling fluid in the passage 15 (S5); when the temperature T2 is lower than the preset temperature value To2 (T2 < To2), the valve 21 is closed by the opening/closing command V2 from the controller 23 (S6).

As the valve 21 is closed, the valve 16 is changed over from position 1 to position 2 by the changeover command V1 from the controller 23 and is closed. As a result, injection of the fluid 25 into the passage 15 is stopped (S7) and is completed.

As the valve 16 is closed, temperature T3 of the urgently cooling fluid in the passage 15 detected by the sensor 24 is sent to the controller 23 where the detected temperature T3 is compared with a preset temperature value To3 of the urgently cooling fluid in the passage 15 (S8). When the temperature T3 does not exceed the preset temperature value To3 (i.e., not T3 > To3), the temperature T4 of the heating fluid detected by the sensor 22 and sent to the controller 23 is compared with a preset temperature value To4 of the heating fluid (S9).

When the temperature T4 is lower than the preset value To4 (T4 < To4), a duration L2 of such status is compared with a preset duration Lo2 (S10). When the duration L2 is grater than preset duration Lo2 (L2 > Lo2), the changeover command V1 is sent from the controller 23 to the valve 16 so that the valve 16 is changed over from position 2 to position 3, i.e., the closed valve 16 is opened, which causes the passages 19 to communicate with the passage 15 (S11).

As the valve 16 is changed over from position 2 to position 3, the fluidal heat mover 26 from the bath 20 is started to be injected via the passage 19 and valve 16 into the passage 15 while the valve 21 is opened by opening/closing command V2 from the controller 23 (S12).

As the valve 21 is opened, an opened period Tm1 of the valve 21 is counted by the timer in the controller 23 and is compared with a preset opened period Tmo1 of the valve (S13); when the opened period Tm1 exceeds the preset opened period Tmo1 (Tm1 > Tmo1), the valve 21 is closed by the opening/closing command V2 from the controller 23 (S14). Then, by the changeover command V1 from the controller 23, the valve 16 is changed over from position 3 to position 2 and is closed (S15). Thus, the injection of the fluidal heat mover 26 to the passage 15 is completed and the normal operation is restarted.

According to the embodiment, when the heating fluid 8 in the passage 7 reaches the predetermined temperature, the urgently cooling fluid 25 is injected into the passage 15 for cooling. As a result, the thermoelectric elements 1 and 2 are not exposed to abnormally high temperature and are prevented from being deteriorated, leading to satisfactory retaining of performances.

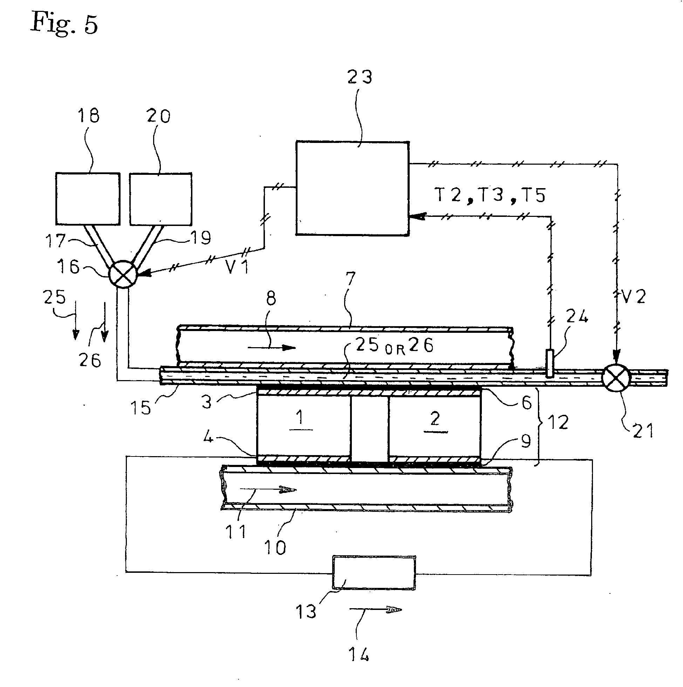

Figs. 5-7 show a second embodiment of the invention in which parts identical with those in Fig. 2 are represented by the same reference characters and the fundamental structure is substantially same as that shown in Fig. 2. In this embodiment, there is no temperature sensor 22 for detection of temperature in the passage 7.

Also in the thermoelectric generating device of the embodiment, during a normal operation, changeover and closure valves 16 and 21 in a passage 15 are closed, the passage 15 downstream of the valve 16 and upstream of the valve 21 being charged with fluidal heat mover 26. Heating fluid 8 such as vehicle exhaust gas is fed through the passage 7 in a direction of arrow while cooling fluid 11 such as water is fed through the passage 10 in a direction of arrow. Thus, also in the embodiment, electricity is generated just like the case of Fig. 2.

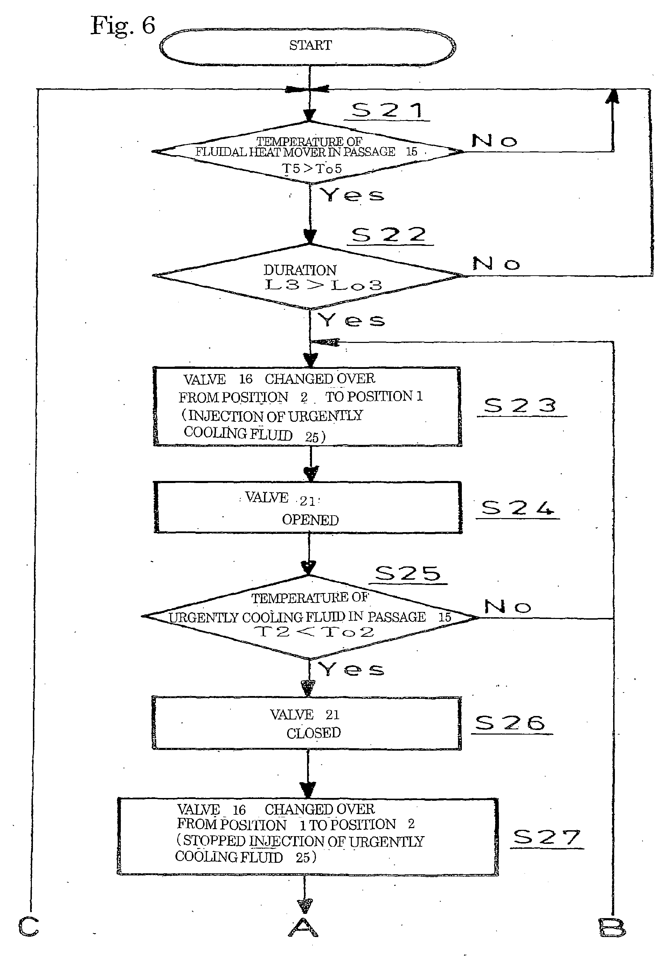

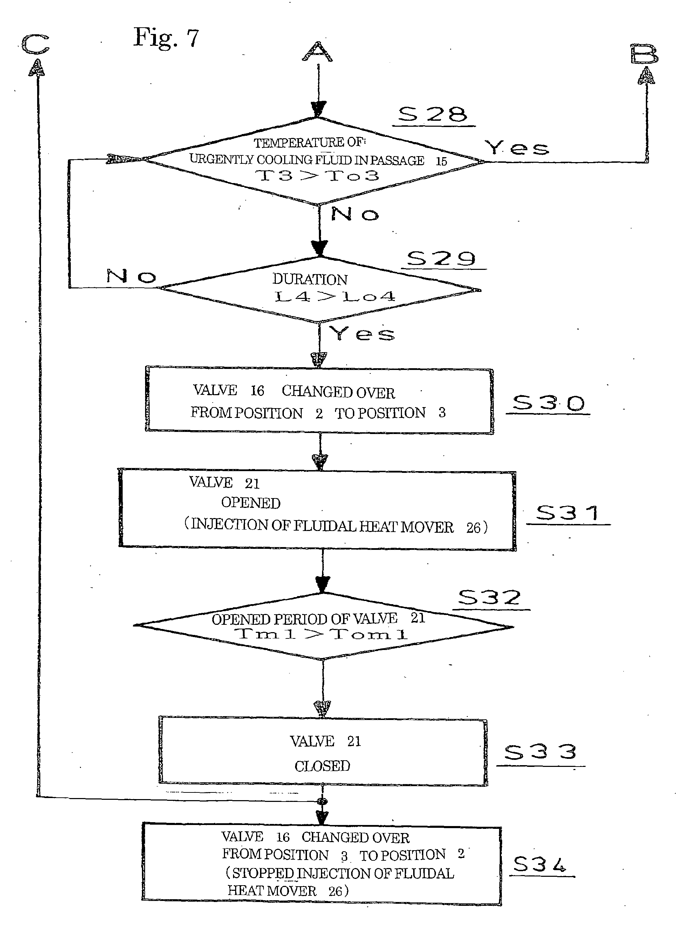

In the embodiment, temperature of the fluidal heat mover 26 in the passage 15 is detect for control in order to prevent the elements 1 and 2 from being exposed to abnormally high temperature (see Figs. 6 and 7). More specifically, during the operation, temperature T5 of the fluidal heat mover 26 in the passage 15 is detected by a temperature sensor 24 and is sent to a controller 23.

In the controller 23, the temperature T5 is compared with a preset upper limit To5 of the fluidal heat mover in the passage 15 preset in the controller 23 (S21); when the temperature T5 is higher than the preset upper limit To5 (T5 > To5), a duration L3 is detected by a timer in the controller 23. The detected duration L3 is compared with a preset duration Lo3 preset in the controller 23 (S22); when the duration L3 is greater than the preset duration Lo3 (L3 > Lo3), a changeover command V11 is sent from the controller 23 to the valve 16.

As a result, the valve 16 is changed over from position 2 to position 1, which causes passages 17 to communicate with the passage 15, the urgently cooling fluid 25 from the bath 18 being passed through the passage 17 and valve 16 and being injected into the passage 15 (S23). As the valve 16 is changed over from position 2 to position 1, the valve 21 is opened by the opening/closing command V2 from the controller 23 (S24). As a result, fluidal heat mover 26 having been retained in the passage 15 is urged by the fluid 25 and discharged out downstream of the valve 21. During the valve 21 being opened, the urgently cooling fluid 25 is also discharged out downstream of the valve 21.

Temperature T2 of the urgently cooling fluid 25 injected into the passage 15 is detected by the sensor 24 and is sent to the controller 23 where the detected temperature T2 is compared with a preset temperature value To2 of the urgently cooling fluid in the passage 15 (S25); when the temperature T2 is lower than the preset temperature value To2 (T2 < To2), the valve 21 is closed by valve opening/closing command V2 from the controller 23 (S26).

As the valve 21 is closed, the valve 16 is changed over from position 1 to position 2 by the changeover command V1 from the controller 23 and is closed. As a result, injection of the fluid 25 into the passage 15 is stopped (S27) and is completed.

As the valve 16 is closed, temperature T3 of the urgently cooling fluid in the passage 15 detected by the sensor 24 is sent to the controller 23 where the detected temperature T3 is compared with a preset temperature value To3 of the urgently cooling fluid in the passage 15 (S28). When the temperature T3 does not exceed the preset temperature value To3 of the urgently cooling fluid (i.e., not T3 > To3), a duration L4 is counted by the timer in the controller 23 (S29); when the duration L4 exceeds a preset duration Lo4 (L4 > Lo4), the changeover command V1 is sent from the controller 23 to the valve 16, so that the valve 16 is changed over from position 2 to position 3, i.e., the closed valve 16 is opened, which causes the passages 19 to communicate with the passage 15 (S30).

As the valve 16 is changed over from position 2 to position 3, the fluidal heat mover 26 from the bath 20 is started to be injected via the passage 19 and valve 16 into the passage 15 while the valve 21 is opened by the opening/closing command V2 from the controller 23 (S31).

As the valve 21 is opened, an opened period Tm1 of the valve is counted by the timer and is compared with a preset value Tmo1 of the valve (S32); when the opened period Tm1 exceeds the preset opened period Tmo1 (Tm1 > Tmo1), the valve 21 is closed by the opening/closing command V2 from the controller 23 (S33). Then, by the changeover command V1 from the controller 23, the valve 16 is changed over from position 3 to position 2 and is closed (S34). Thus, injection of fluidal heat mover 26 to the passage 15 is completed and the normal operation is restarted.

According to the embodiment, when the fluidal heat mover 26 in the passage 15 reaches the predetermined temperature, the urgently cooling fluid 25 is injected into the passage 15 for cooling. As a result, the thermoelectric elements 1 and 2 are not exposed to abnormally high temperature and are prevented from being deteriorated, leading to satisfactory retaining of performances.

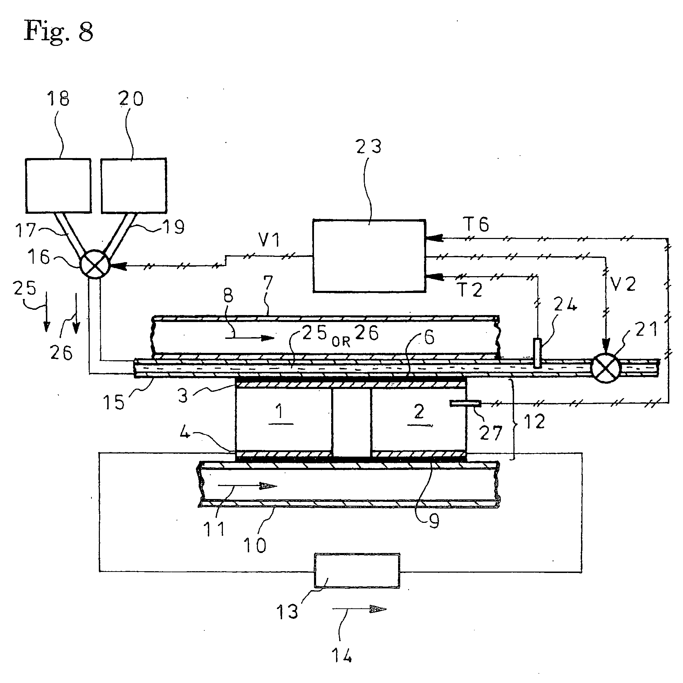

Figs. 8-10 show a third embodiment of the invention in which parts identical with those in Figs. 2 and 5 are represented by the same reference characters and the fundamental structure is substantially same as those shown in Figs. 2 and 5. In the figures, reference numeral 27 denotes a temperature sensor such as a thermocouple arranged on a high-temperature side of n-type thermoelectric element 2, detected temperature T6 by a temperature sensor 27 being adapted to be sent to a controller 23.

Thus, also in the thermoelectric generating device according to the embodiment, electricity is generated just like the cases of Figs. 2 and 5; explanation thereon will be omitted.

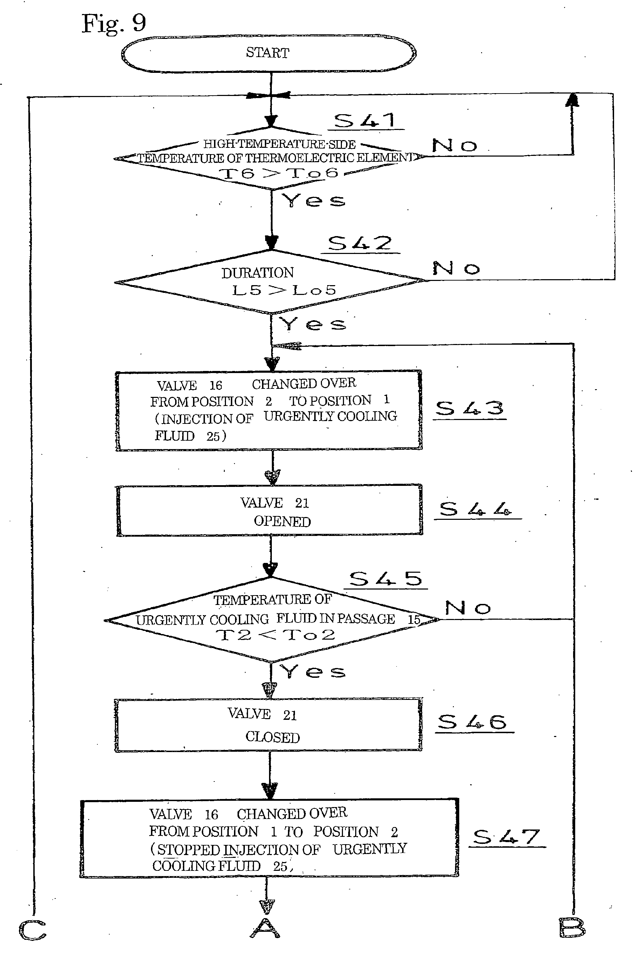

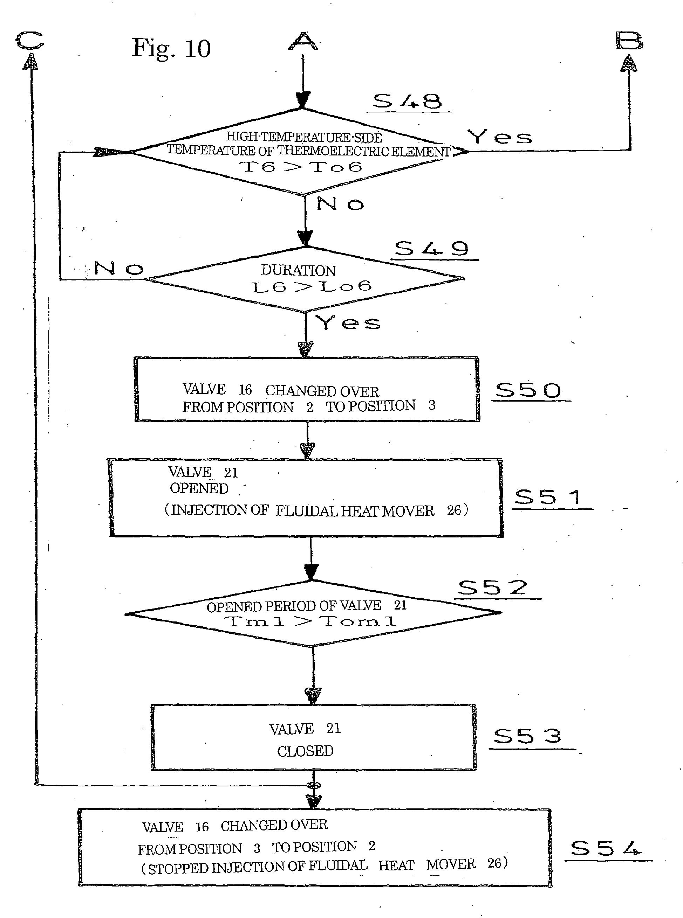

In the embodiment, in order to prevent the thermoelectric elements 1 and 2 from being exposed to abnormally high temperature, the high-temperature side temperature of the element 2 and temperature of urgently cooling fluid 25 in a passage 15 are detected for control (see Figs. 9 and 10). More specifically, during the operation, the high-temperature side temperature T6 of the thermoelectric element is detected by the sensor 27 and is sent to the controller 23.

Thus, in the controller 23, the temperature T6 is compared with a preset upper limit To6 of the high-temperature side temperature of the thermoelectric element preset in the controller 23 (S41); when the temperature T6 is higher than the preset upper limit To6 (T6 > To6), a duration L5 is detected by a timer in the controller 23. The detected duration L5 is compared with the preset duration Lo5 preset in the controller 23 (S42); when the duration L5 is greater than the preset duration Lo5 (L5 > Lo5), the changeover command V1 is sent from the controller 23 to the valve 16.

As a result, the valve 16 is changed over from position 2 to position 1, which causes the passage 17 to communicate with the passage 15, so that the urgently cooling fluid 25 from the bath 18 is passed through the passage 17 and valve 16 and is injected into the passage 15 (S43). As the valve 16 is changed over from position 2 to position 1, the valve 21 is opened by opening/closing command V2 from the controller 23 (S44). As a result, the fluidal heat mover 26 having being retained in the passage 15 is urged by the fluid 25 and discharged out downstream of the valve 21. During the valve 21 is opened, the urgently cooling fluid 25 is also discharged out downstream of the valve 21.

Temperature T2 of the urgently cooling fluid 25 injected into the passage 15 is detected by the sensor 24 and is sent to the controller 23 where the detected temperature T2 is compared with a preset temperature value To2 of the urgently cooling fluid in the passage 15 (S45); when the temperature T2 is lower than the preset temperature value To2 (T2 < To2), the valve 21 is closed by the opening/closing command V2 from the controller 23 (S46).

As the valve 21 is closed, the valve 16 is changed over from position 1 to position 2 by the changeover command V1 from the controller 23 and is closed. As a result, injection of the fluid 25 into the passage 15 is stopped (S47) and is completed.

As the valve 16 is closed, high-temperature side temperature T6 of the thermoelectric element detected by the sensor 27 is sent to the controller 23 where the detected temperature T6 is compared with the preset upper limit To6 (S48). When the temperature T6 does not exceed the preset upper limit To6 of the high-temperature side temperature of the thermoelectric element (i.e., not T6 > To6), a duration L6 of such status is counted by the timer in the controller 23 (S49). When the duration L6 is greater than the preset duration Lo6 (L6 > Lo6), the changeover command V1 is sent from the controller 23 to the valve 16 so that the valve 16 is changed over from position 2 to position 3, i.e., the closed valve 16 is opened, which causes the passage 19 to communicate with the passage 15 (S50).

As the valve 16 is changed over from position 2 to position 3, the fluidal heat mover 26 from the bath 20 is started to be injected via the passage 19 and valve 16 into the passage 15 while the valve 21 is opened by the opening/closing command V2 from the controller (S51).

As the closure valve 21 is opened, an opened period Tm1 of the valve is counted by the timer in the controller 23 and is compared with a preset opened period Tmo1 of the valve (S52); when the opened period Tm1 exceeds the preset value Tmo1 (Tm1 > Tmo1), the valve 21 is closed by the opening/closing command V2 from the controller 23 (S53). Then, by changeover command V1 from the controller 23, the valve 16 is changed from position 3 to position 2 and is closed (S54). Thus, the injection of the fluidal heat mover 26 to the passage 15 is completed and the normal operation is restarted.

According to the embodiment, when the thermoelectric element 2 reaches the predetermined temperature, the urgently cooling fluid 25 is injected into the passage 15 for cooling. As a result, the thermoelectric elements 1 and 2 are not exposed to abnormally high temperature and are prevented from being deteriorated, leading to satisfactory retaining of performances.

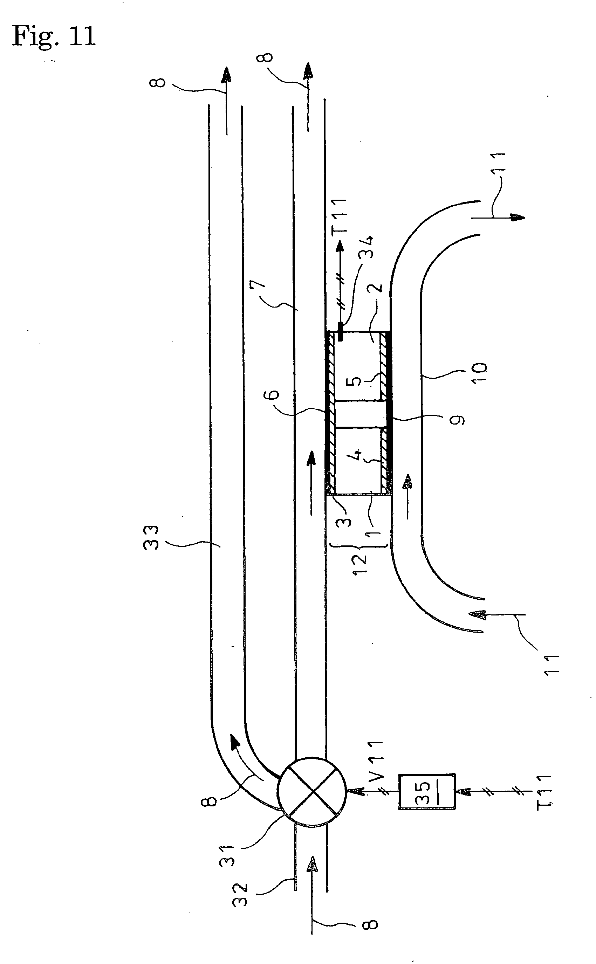

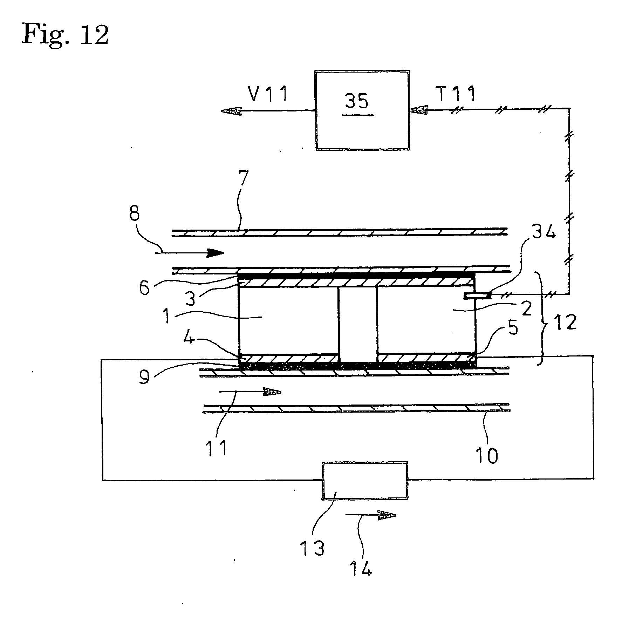

Figs. 11-13 show a fourth embodiment of the invention in which a thermoelectric module 12 is similar in fundamental structure to that of the conventional one shown in Fig. 1 and the parts identical with those in Fig. 1 are represented by the same reference characters.

An end in a passage 7 upstream of an arrangement of the module 12 in the direction of flow of heating fluid 8 is connected with a changeover valve 31. The valve 31 is connected with a passage 32 through which the heating fluid 8 flows from upstream and with a bypass passage 33 which bypasses the passage 7 for feeding of the heating fluid 8 upon abnormally high temperature.

A temperature sensor 34 such as a thermocouple is arranged on a high-temperature side of n-type thermoelectric element 2, detected temperature T11 by the sensor 34 being adapted to be sent to a controller 35. A changeover command V11 is adapted to be sent from the controller 35 to the valve 31.

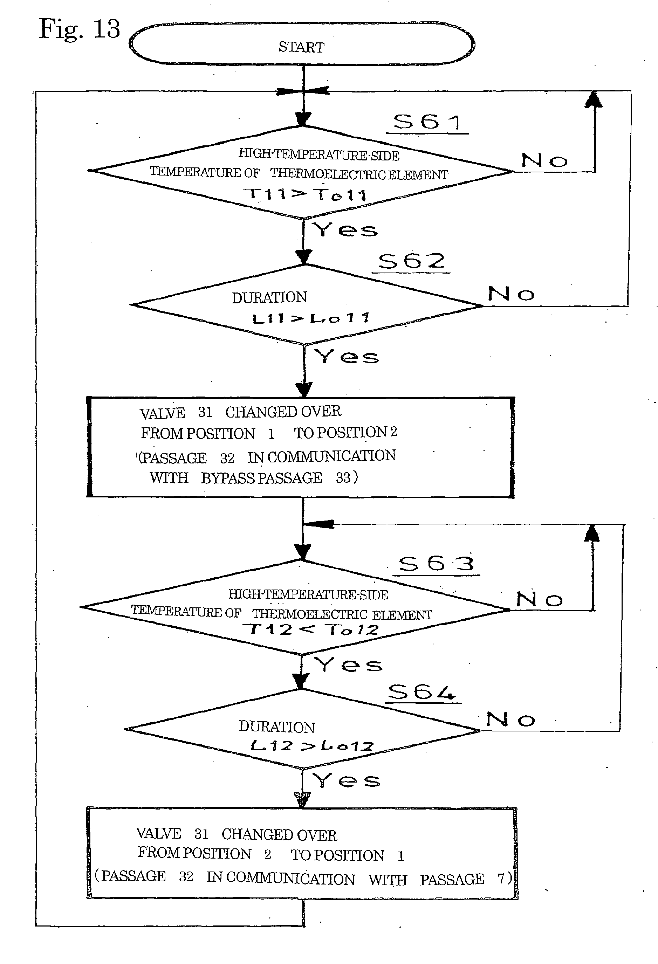

Next, mode of operation of the above embodiment will be described with reference also to Fig. 13. In Fig. 13, position 1 represents a status upon electric generation where the valve 31 has been changed over so as to feed the heating fluid 8 from the passage 32 to the passage 7; and position 2, status of cooling the thermoelectric elements where the valve 31 has been changed over so as to feed the heating fluid 8 from the passage 32 to the bypass passage 33.

In the thermoelectric generating device of the embodiment, during a normal operation, the changeover valve 31 has been changed over to position 1, which causes the passages 32 to communicate with the passage 7 and shuts off the communication between the passage 32 and bypass passage 33. As a result, heating fluid 8 such as vehicle exhaust gas is fed through the passages 32 and 7 in the direction of arrows. Cooling fluid 11 such as water is fed through a passage 10 in the direction of arrows.

As a result, sides of the p- and n-type thermoelectric elements 1 and 2 on the electrode plate 3 (one side of the thermoelectric module 12) are heated while sides of the elements 1 and 2 respectively on electrode plates 4 and 5 (the other side of the module 12) are cooled, so that potential difference is caused between opposite ends of the elements 1 and 2 due to temperature difference. Thus, electric current 14 caused by the potential difference is fed to a load 13.

In the embodiment, the direction of flow of the heating fluid 8 is controlled so as to prevent the thermoelectric elements 1 and 2 from being exposed to abnormally high temperature. More specifically, during the operation, the high-temperature side temperature of the element 2 is detected by the sensor 34, the detected temperature T11 being sent to the controller 35.

Thus, in the controller 35, the temperature T11 is compared with a preset value To11 of high-temperature side temperature of the element preset in the controller 35 (S61). When the temperature T11 is greater than the preset value To11 (T11 > To11), a duration L11 of the status is counted (S62); when the counted duration L11 exceeds a preset duration Lo11 (L11 > Lo11), changeover command V11 is sent from the controller 35 to the valve 31 so that the valve 31 is changed over from position 1 to position 2.

As a result, the passage 32 is caused to communicate with the bypass passage 33 while the communication between the passages 32 and 7 is shut off, so that heating fluid 8 from the passage 32 is introduced via the valve 31 into the bypass passage 33 and is fed through the bypass passage 33 downstream.

Even when the heating fluid 8 is fed not to the passage 7 but to the bypass passage 33, the high-temperature side temperature of the element 2 is detected by the sensor 34 (S63); when the detected temperature T12 is lower than a preset value To12 of the high-temperature side temperature of the element (T12 < To12), a duration L12 of such status is counted (S64). When the counted duration L12 exceeds a preset duration Lo12 (L12 > Lo12), changeover command V11 is sent from the controller 35 to the valve 31 so that the valve 31 is changed over from position 2 to position 1.

As a result, the passage 32 is caused to communicate with the passage 7 while the communication between the passage 32 and bypass passage 33 is shut off, so that the heating fluid 8 is fed again from the passage 32 to the passage 7, whereby electric generation due to heating and cooling of the thermoelectric module 12 is started.

According to the embodiment, when the thermoelectric element 2 reaches the predetermined temperature, the heating fluid 8 is not fed to the passage 7, so that the thermoelectric elements 1 and 2 are not exposed to abnormally high temperature. As a result, deterioration is prevented and performances can be satisfactorily retained; when the heating fluid 8 is for example a vehicle exhaust gas, exhaust heat can be effectively recovered.

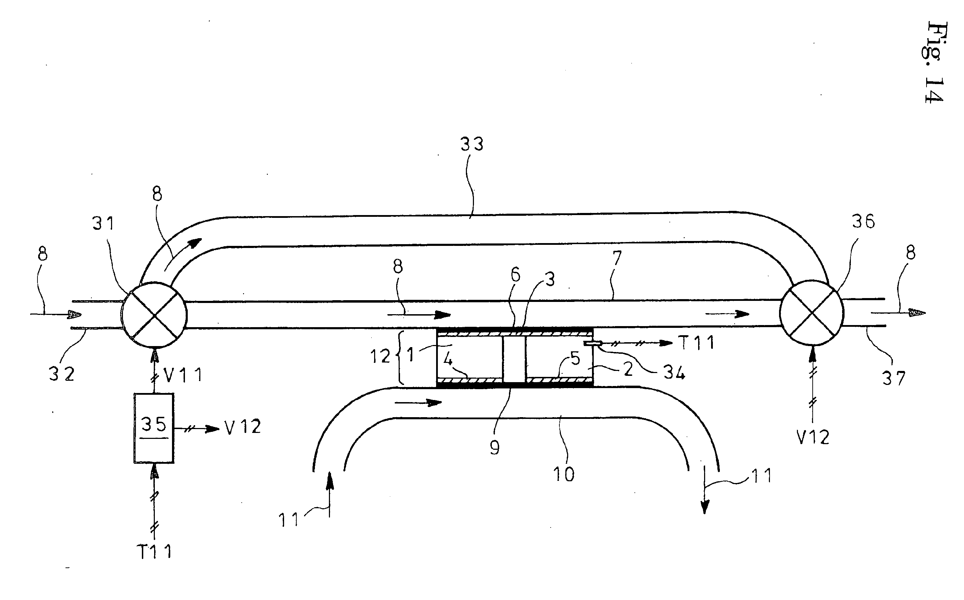

Figs. 14-16 show a fifth embodiment of the invention in which the parts identical with those in Fig. 11 are represented by the same reference characters; a thermoelectric module 12 is similar in fundamental structure to that shown in Fig. 1.

In the embodiment, an end in a passage 7 upstream of an arrangement of the module 12 in the direction of flow of heating fluid 8 is connected with a changeover valve 31. The valve 31 is connected with a passage 32 through which the heating fluid 8 flows from upstream and with a bypass passage 33 which bypasses the passage 7 for feeding of the heating fluid 8 upon abnormally high temperature. An end in the passage 7 downstream of the arrangement of the module 12 in the direction of flow of the heating fluid 8 is connected to a changeover valve 36. The valve 36 is connected with a downstream end of the bypass passage 33 and with a passage 37 which feeds downstream the heating fluid 8 from the passage 7 or from the bypass passage 33.

A temperature sensor 34 such as a thermocouple is arranged on a high-temperature side of n-type thermoelectric element 2, detected temperature T11 by the sensor 34 being adapted to be sent to a controller 35. The controller 35 is adapted to send changeover commands V11 and V12 to the valves 31 and 36, respectively.

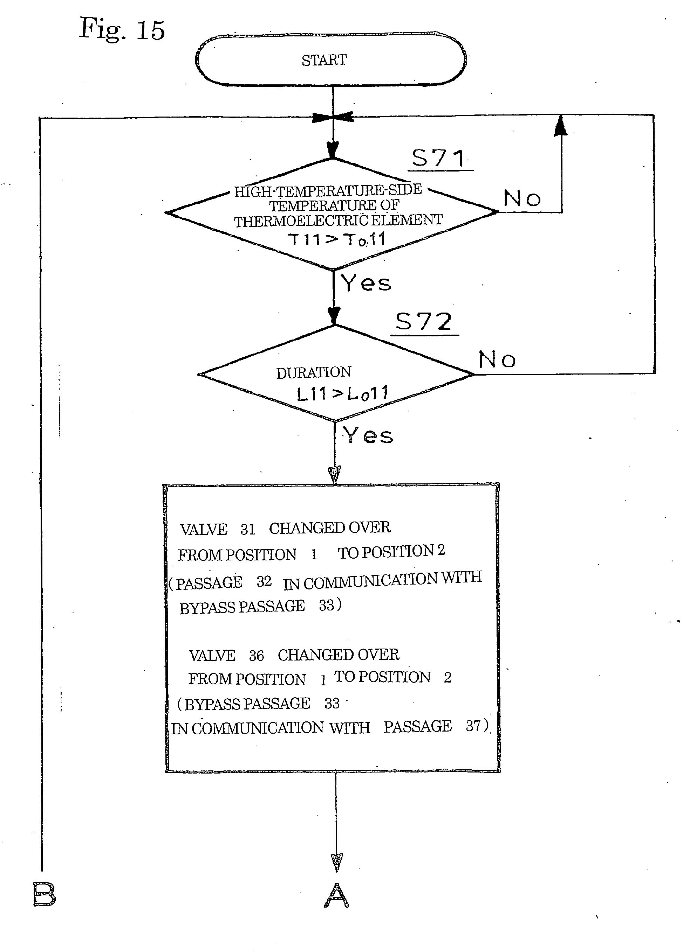

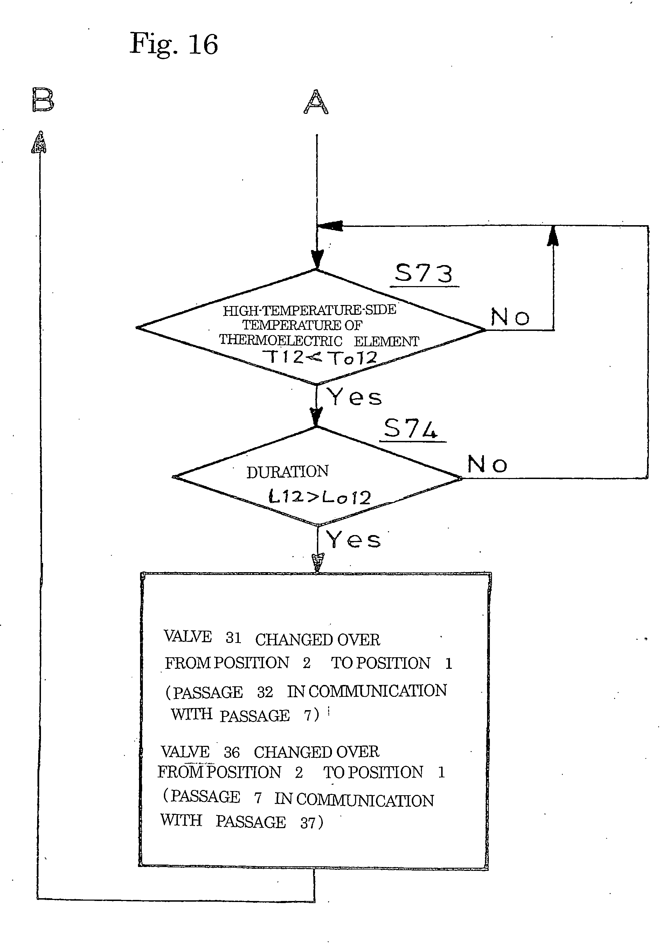

Next, mode of operation of the above embodiment will be described also with reference to Figs. 15 and 16 in which position 1 represents a status of electric generation where the valve 31 has been changed over so as to feed the heating fluid 8 from the passage 32 to the passage 7, and the valve 36 has been changed over so as to feed the heating fluid 8 from the passage 7 to the passage 37. Position 2 represents a status of cooling the thermoelectric elements where the valve 31 has been changed over so as to feed the heating fluid 8 from the passage 32 to the bypass passage 33, and the valve 36 has been changed over so as to feed the heating fluid 8 via the bypass passage 33 to the passage 37. Characters A and B represent flow connections.

In the thermoelectric generating device of the embodiment, during a normal operation, the valves 31 and 36 have been changed over to position 1, the passages 32, 7 and 37 being in communication with each other. Thus, the heating fluid 8 such as vehicle exhaust gas is fed through the passages 32, 7 and 37 in the direction of arrows. The cooling fluid 11 such as water is fed through the passage 10 in the direction of arrows.

As a result, sides of the thermoelectric elements 1 and 2 on the electrode plate 3 (one side of the thermoelectric module 12) are heated while sides of the elements 1 and 2 respectively on the electrode plates 4 and 5 (the other side of the module 12) are cooled. Thus, in the thermoelectric module 12, electricity is generated just like the above.

In the embodiment, the direction of flow of the heating fluid 8 is controlled so as to prevent the thermoelectric elements 1 and 2 from being exposed to abnormally high temperature. More specifically, during the operation, the high-temperature side temperature of the element 2 is detected by the sensor 34, the detected temperature T11 being sent to the controller 35.

Thus, in the controller 35, the temperature T11 is compared with a preset value To11 of the high-temperature side temperature of the element preset in the controller 35 (S71). When the temperature T11 is greater than the preset value To11 (T11 > To11), a duration L of such status is counted (S72); when the counted duration L11 exceeds a preset duration Lo11 (L11 > Lo11), the changeover command V11 is sent from the controller 35 to the valve 31 so that the valve 31 is changed over from position 1 to position 2, changeover command V12 being sent from the controller 35 to the valve 36 so that the valve 36 is changed over from position 1 to position 2.

Thus, the passages 32, bypass passage 33 and passage 37 are in communication with each other, the communication between the passages 32 and 7 and that between the passages 7 and 37 being shut off. As a result, the heating fluid 8 is passed through the passage 32 and bypass passage 33 to the passage 37 and is fed downstream.

Even when the heating fluid 8 is fed not to the passage 7 but to the bypass passage 33, the high-temperature side temperature of the element 2 is detected by the sensor 34 (S73); when the detected temperature T12 is lower than a preset value To12 of the high-temperature side temperature of the element (T12 < To12), a duration L12 of its status is counted (S74). When the counted duration L12 exceeds a preset duration Lo12 (L12 > Lo12), changeover command V11 is sent from the controller 35 to the valve 31 so that the valve 31 is changed over from position 2 to position 1, changeover command V12 being sent from the controller 35 to the valve 36 so that the valve 36 is changed over from position 2 to position 1.

As a result, the passages 32, 7 and 37 are caused to be in communication with each other while the communications between the passage 32, bypass passage 33 and passage 37 are shut off, and thus the heating fluid 8 is fed again through the passage 32, passage 7 and passage 37, whereby electric generation due to heating and cooling of the thermoelectric module 12 is started.

According to the embodiment, when the thermoelectric element 2 reaches the predetermined temperature, the heating fluid 8 is not fed to the passage 7, so that the thermoelectric elements 1 and 2 are not exposed to abnormally high temperature. As a result, deterioration is prevented and performances can be satisfactorily retained; when the heating fluid 8 is for example a vehicle exhaust gas, exhaust heat can be effectively recovered.

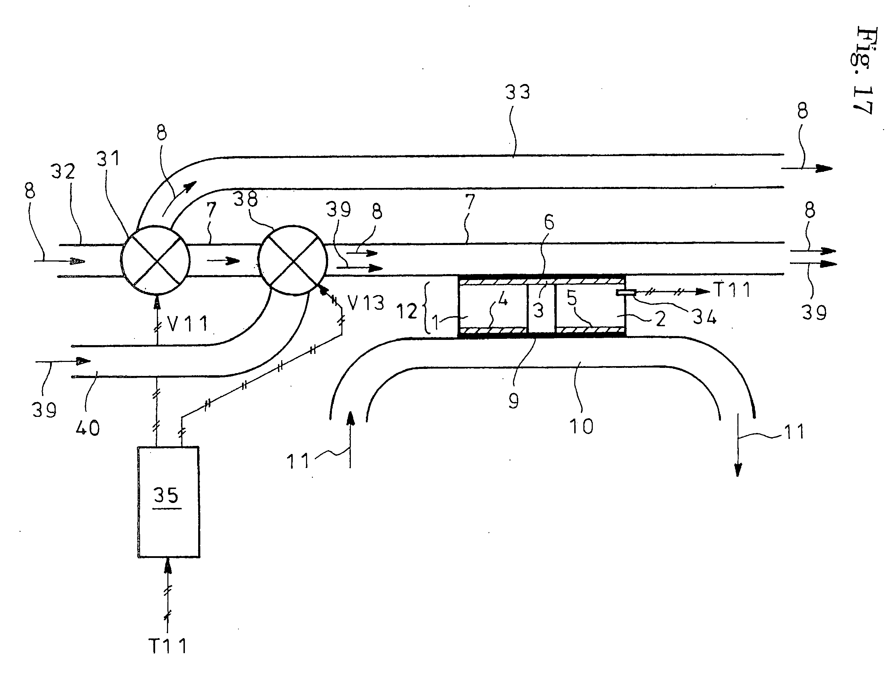

Figs. 17-19 show a sixth embodiment of the invention in which the parts identical with those in Fig. 1 are represented by the same reference characters; a thermoelectric module 12 is similar in fundamental structure to that shown in Fig. 1.

In the embodiment, an end of a passage 7 upstream of an arrangement of the thermoelectric module 12 in the direction of flow of heating fluid 8 is connected with the changeover valve 31. The valve 31 is connected with a passage 32 through which the heating fluid 8 flows from upstream and with a bypass passage 33 which bypasses the passage 7 for feeding of the heating fluid 8 upon abnormally high temperature. Arranged intermediately in the passage 7 upstream of the module 12 is a changeover valve 38 with which connected is a passage 40 for feeding urgently cooling fluid 39 such as cooling air to the passage 7 downstream of the valve 38.

A temperature sensor 34 such as a thermocouple is arranged on a high-temperature side of n-type thermoelectric element 2, temperature T11 detected by the sensor 34 being adapted to be sent to a controller 35. The controller 35 is adapted to send changeover commands V11 and V13 to the valves 31 and 38, respectively.

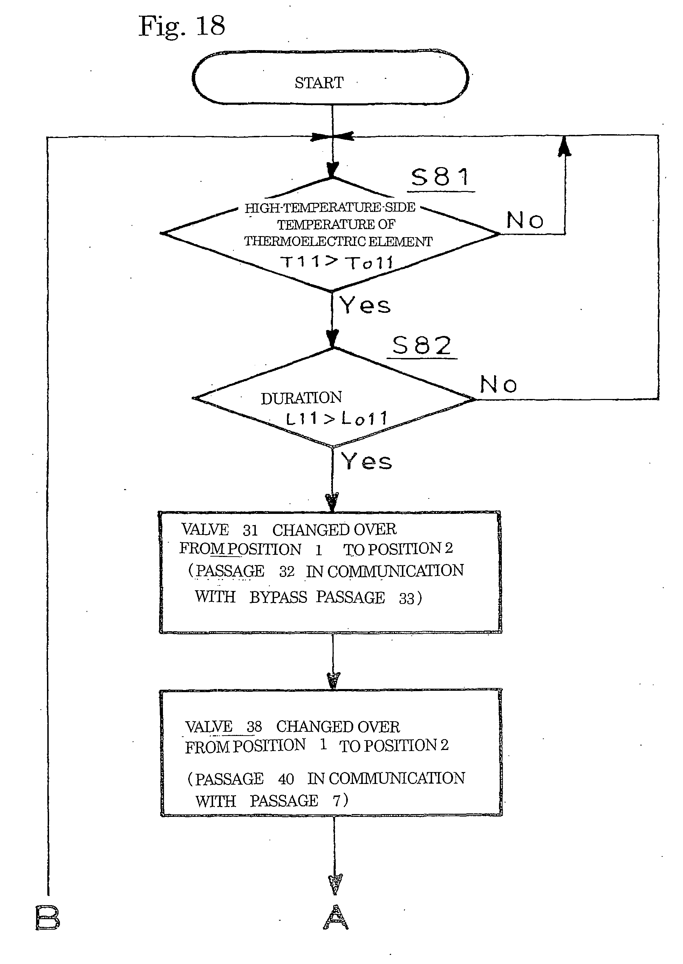

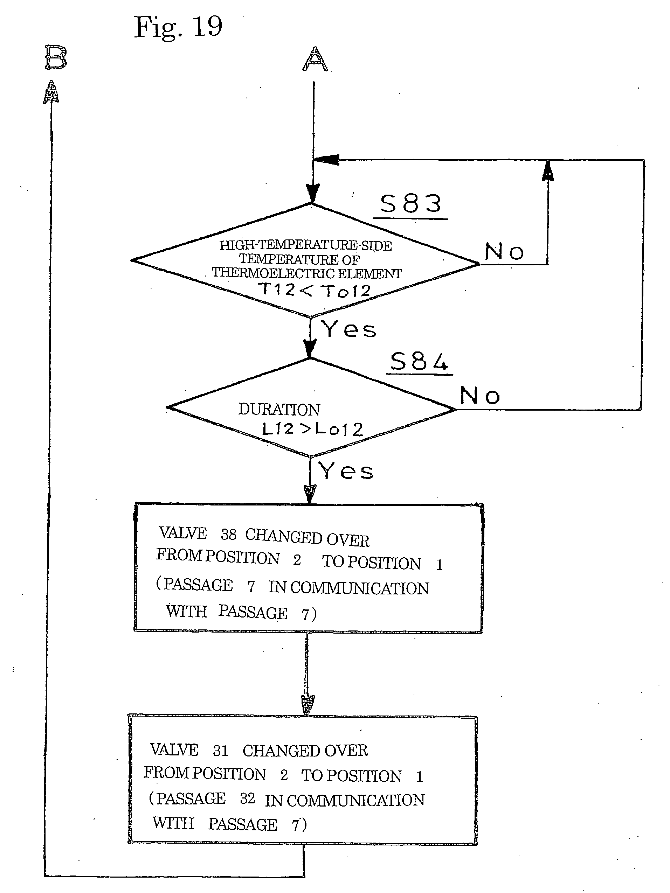

Next, mode of operation of the above embodiment will be described also with reference to Figs. 18 and 19 in which position 1 represents a status of electric generation where the valve 31 has been changed over so as to feed heating fluid 8 from the passage 32 to the passage 7; and the valve 38 has been changed over so as to feed the heating fluid 8 from the passage 7 upstream of the valve 38 to the passage 7 downstream of the valve 38. Position 2 represents a status of cooling the thermoelectric elements where the valve 31 has been changed over so as to feed the heating fluid 8 from the passage 32 to the bypass passage 33; and the valve 38 has been changed over so as to feed the urgently cooling fluid 39 from the passage 40 to the passage 7. Characters A and B represent flow connections.

In the thermoelectric generating device of the embodiment, during a normal operation, the valves 31 and 38 have been changed over to position 1, the passages 32 and portions of the passage 7 upstream and downstream of the valve 38 being in communication with each other, the communication between the passage 32 and bypass passage 33 and between the passages 40 and 7 being shut off. Thus, the heating fluid 8 is fed through the passages 32 and 7 in the direction of arrows; the cooling fluid 11, through the passage 10 in the direction of arrows.

As a result, sides of the p- and n-type thermoelectric elements 1 and 2 on the electrode plate (one side of the thermoelectric module 12) are heated while sides of the elements 1 and 2 respectively on the electrode plates 4 and 5 (the other side of the module 12) are cooled. Thus, in the thermoelectric module 12, electric generation is conducted just like the above.

In the embodiment, the direction of flow of the heating fluid 8 is controlled so as to prevent the thermoelectric elements 1 and 2 from being exposed to abnormally high temperature, the urgently cooling fluid 39 being fed through the passage 7. More specifically, during the operation, a high-temperature side temperature of the thermoelectric element 2 is detected by the sensor 34, the detected temperature T11 being sent to the controller 35.

In the controller 35, the temperature T11 is compared with a preset value To11 of the high-temperature side temperature of the element preset in the controller 35 (S81). When the temperature T11 is greater than the preset value To11 (T11 > To11), a duration L11 of such status is counted (S82); when the counted duration L11 exceeds a preset duration Lo11 (L11 > Lo11), changeover command V11 is sent from the controller 35 to the valve 31 so that the valve 31 is changed over from position 1 to position 2, changeover command V13 being sent from the controller 35 to the valve 38 so that the valve 38 is changed over from position 1 to position 2. Thus, the passage 32 is caused to communicate with the bypass passage 33, and the passage 40 is caused to communicate with the portion of the passage 7 downstream of the valve 38, the communication between the passages 32 and 7 being shut off.

As a result, the heating fluid 8 is fed from the passage 32 into the bypass passage 33 and flows downstream. The urgently cooling fluid 39 is fed from the passage 40 into the portion of the passage 7 downstream of the valve 38 and flows through the passage 7 downstream. Thus, thermoelectric elements 1 and 2 of the thermoelectric module 12 are urgently cooled.

Even when the heating fluid 8 is fed to the bypass passage 33 and the urgently cooling fluid 39 is fed through the passage 7, the high-temperature side temperature of the element 2 is detected by the sensor 34 (S83); when the detected temperature T12 is lower than a preset value To12 of the high-temperature side temperature of the element (T12 < To12), a duration L12 of such status is counted (S84). When the counted duration L12 exceeds the preset duration Lo12 (L12 > Lo12), changeover command V13 is sent from the controller 35 to the valve 38 so that the valve 38 is changed over from position 2 to position 1, changeover command V11 being sent from the controller 35 to the valve 31 so that the valve 31 is changed over from position 2 to position 1.

As a result, the passage 32 and the portions of the passage 7 upstream and downstream of the valve 38 are in communication with each other, the communications between the passage 7 and bypass passage 33 and between the passages 7 and 40 being shut off. As a result, the introduction of the fluid 39 to the passage 7 is stopped while the heating fluid 8 is fed from the passage 32 to the passage 7, so that electric generation of the thermoelectric module 12 is restarted.

According to the embodiment, when the thermoelectric element 2 reaches a predetermined temperature, not the heating fluid 8 but the urgently cooling fluid 39 is fed to the passage 7. Thus, the thermoelectric elements 1 and 2 are urgently cooled and are not exposed to abnormally high temperature. As a result, deterioration is prevented and performances can be further satisfactorily retained; when the heating fluid 8 is for example a vehicle exhaust gas, exhaust heat can be effectively recovered.

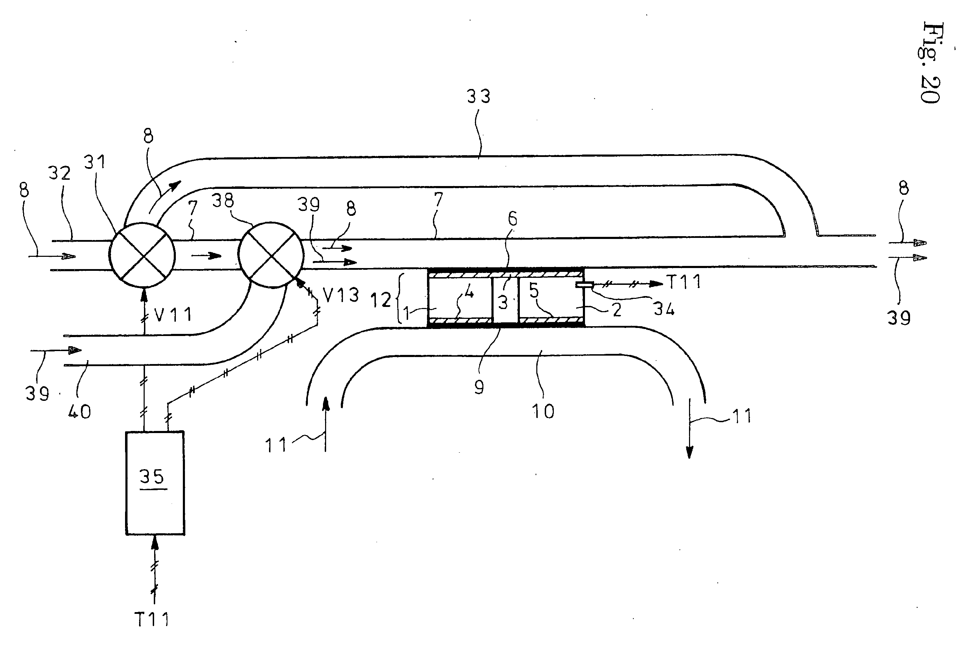

Fig. 20 shows a seventh embodiment of the invention in which parts identical with those in Fig. 17 are represented by the same reference characters; a thermoelectric module 12 is similar in fundamental structure to that shown in Fig. 1. Respective passages are substantially similar in structure to those shown in Fig. 17 except that a downstream end of a bypass passage 33 is connected to the passage 7 at a point downstream of the thermoelectric module 12. Thus, the changeover positions of the valves 31 and 38 upon electric generation by the thermoelectric module 12 and upon cooling of the elements 1 and 2 are utterly the same as those in Fig. 17; control flow is utterly the same as that in Figs. 18 and 19. The heating fluid 8, which has flown into the bypass passage 33 upon cooling of the thermoelectric module 12 finally flows out into the passage 7 downstream of the module 12.

Also in the embodiment, just like the seventh embodiment, when the thermoelectric element 2 reaches a predetermined temperature, not the heating fluid 8 but the urgently cooling fluid 39 is fed to the passage 7. Thus, the thermoelectric elements 1 and 2 are urgently cooled and are not exposed to abnormally high temperature. As a result, deterioration is prevented and performances can be further satisfactorily retained; when the heating fluid 8 is for example a vehicle exhaust gas, exhaust heat can be effectively recovered.

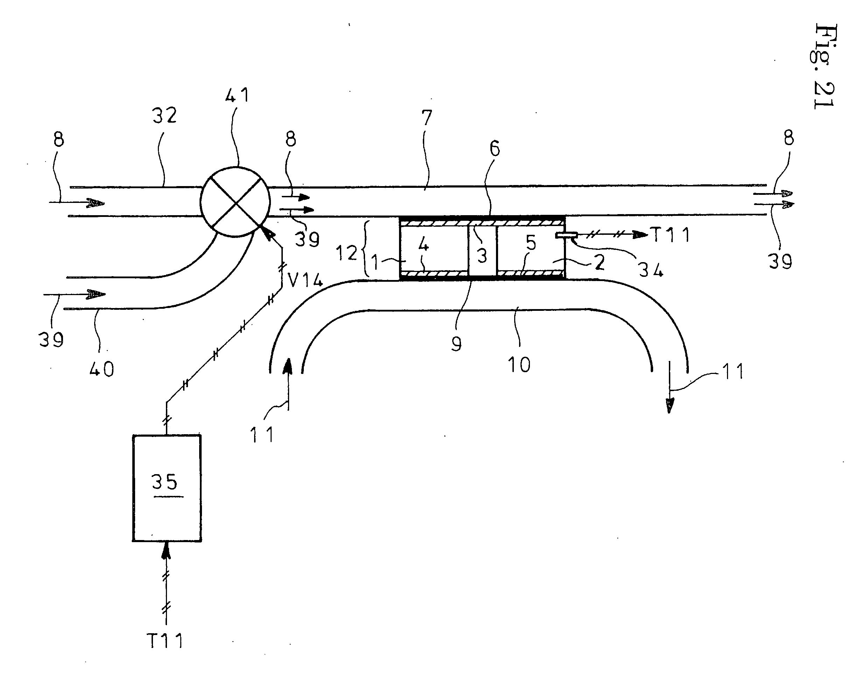

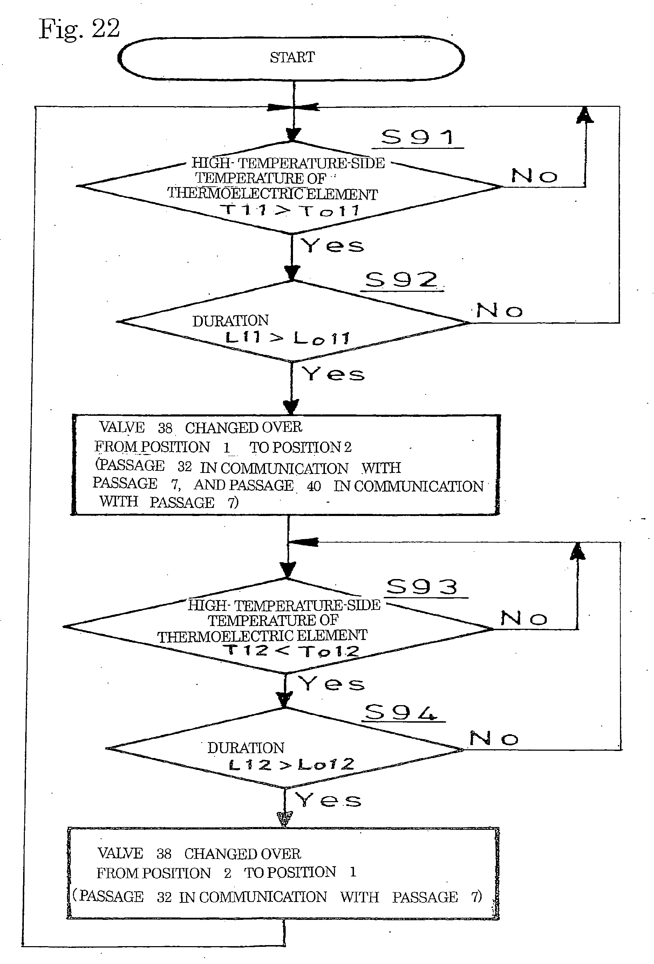

Figs. 21 and 22 show an eighth embodiment of the invention in which parts identical with those in Fig. 11 are represented by the same reference characters. The thermoelectric module 12 is similar in fundamental structure to that shown in Fig. 1.

In the embodiment, connected to an end of the passage 7 upstream of the arrangement of thermoelectric module 12 in the direction of flow of heating fluid 8 is a changeover valve 41. Connected with the valve 41 are a passage 32 feeding the heating fluid 8 from upstream and a passage 40 which is adapted to feed urgently cooling fluid 39 upon abnormally high temperature.

A temperature sensor 34 such as a thermocouple is arranged on a high-temperature side of n-type thermoelectric element 2, detected temperature T11 by the sensor 34 being adapted to be sent to a controller 35. The controller 35 is adapted to send a changeover command V14 to the valve 41.

Next, mode of operation of the above embodiment will be described with reference also to Fig. 22. In Fig. 22, position 1 represents a status upon electric generation where the valve 41 has been changed over so as to feed the heating fluid 8 from the passage 32 to the passage 7; and position 2, status of cooling the thermoelectric elements where the valve 41 has been changed over so as to feed the heating and urgently cooling fluids 8 and 9 from the passages 32 and 40 to the passage 7, respectively.

In the thermoelectric generating device of the embodiment, during a normal operation, the valve 41 has been changed over to position 1, which causes the passage 32 to communicate with the passage 7 while the communication between the passages 40 and 7 is shut off. As a result, the heating fluid 8 is fed through the passages 32 and 7 in the direction of arrows. The cooling fluid 11 is fed through the passage 10 in the direction of arrows.

As a result, sides of the p- and n-type thermoelectric elements 1 and 2 on the electrode plate (one side of the thermoelectric module 12) are heated while the sides of the elements 1 and 2 respectively on the electrode plates 4 and 5 (the other side of the module 12) are cooled, so that electricity is generated in the thermoelectric module 12 in the same way as mentioned above.

In the embodiment, the urgently cooling fluid 39 is adapted to be fed to the passage 7 together with the heating fluid 8 so as to prevent the thermoelectric elements 1 and 2 from being exposed to abnormally high temperature. More specifically, during the operation, the high-temperature side temperature of the thermoelectric element 2 is detected by the sensor 34, the detected temperature T11 being sent to the controller 35.

Thus, in the controller 35, the temperature T11 is compared with a preset value To11 of the high-temperature side temperature of the element preset in the controller 35 (S91). When the temperature T11 is greater than the preset value To11 (T11 > To11), a duration L of such status is counted (S92); when the counted duration L11 exceeds a preset duration Lo11 (L11 > Lo11), changeover command V14 is sent from the controller 35 to the valve 41 so that the valve 41 is changed over from position 1 to position 2. Thus, while the communication between the passages 32 and 7 is retained, the passage 40 is caused to be in communication with the passage 7.

Thus, in addition to the heating fluid 8 fed from the passage 32 to the passage 7, the urgently cooling fluid 39 is fed from the passage 40 to the passage 7. As a result, in the passage 7, the heating fluid 8 and urgently cooling fluid 39 are fed in admixture to cool the thermoelectric module 12.

Even when the heating fluid 8 and urgently cooling fluid 39 are fed together through the passage 7, the temperature of the element 2 is detected by the sensor 34 (S93). When the detected temperature T12 of the high-temperature side of the element is lower than a preset value To12 of the high-temperature side temperature of the element (T12 < To12), a duration L of such status is counted (S94). When the counted duration L12 exceeds a preset duration Lo12 (L12 > Lo12), changeover command V14 is sent from the controller 35 to the valve 41 so that the valve 41 is changed over from position 2 to position 1.

As a result, the passage 32 is caused to be in communication with the passage 7 while the communication between the passages 40 and 7 is shut off, so that only the heating fluid 8 is fed from the passage 32 to the passage 7, and electric generation by the thermoelectric module 12 is restarted.

According to the embodiment, when the thermoelectric element 2 reaches the predetermined temperature, the urgently cooling fluid 39 is fed to the passage 7 together with the heating fluid 8, so that thermoelectric elements 1 and 2 are urgently cooled. Thus, the elements 1 and 2 are prevented from being exposed to abnormally high temperature, so that deterioration is prevented and performances can be further satisfactorily retained; when the heating fluid 8 is for example a vehicle exhaust gas, exhaust heat can be efficiently recovered.

It is to be understood that the invention is not limited to the above embodiments and that various changes and modifications may be made without departing from the scope of the invention. For example, though vehicle exhaust gas has been exemplified as heating fluid in the thermoelectric generating device of the invention mentioned above, various exhaust gases may be applied as the heating fluid, not limited to the vehicle exhaust gas. Newly generated high-temperature gas may use as heating fluid other than exhaust gases. Though the description has been made on detection of high-temperature side temperature of n-type thermoelectric element concerning of detection on temperature of thermoelectric element, the invention may be carried out by detecting temperature on any part of the thermoelectric element. In the fourth to eighth embodiments, the description has been made on high-temperature side temperature of the n-type thermoelectric element; however, the invention may be also carried out by detecting temperature of the passage through which the heating fluid flows so as to heat the thermoelectric module upon electric generation. The description has been made on paired p- and n-type thermoelectric elements; however, the number of set of elements may be any provided that they are connected electrically in series. Though the description has been made on feeding of the generated electric current to the load, alternatively the current may be stored in a battery.

### Industrial Applicability

In a thermoelectric generating device of the invention, high-temperature gas such as vehicle exhaust gas may be utilized as heating fluid for generation of electricity.

## Claims

1. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12), said thermoelectric generating device comprising a third passage arranged between said first passage (7) and said one side of the thermoelectric module (12), said third passage (15) being charged with fluidal heat mover (26) during a normal operation and having urgently cooling fluid (25) injected when the heating fluid (8) in the first passage (7) reaches or exceeds a predetermined temperature.

2. A thermoelectric generating device as claimed in claim 1, wherein the fluidal heat mover (26) in the third passage (15) is discharged and the urgently cooling fluid (25) is injected into the third passage (15) when heating fluid (8) in the first passage (7) is at or above the predetermined temperature for a predetermined duration, and wherein the urgently cooling fluid (25) in the third passage (15) is discharged and the fluidal heat mover (26) is injected into the third passage (15) when the urgently cooling fluid (25) having been injected is at or below a predetermined temperature, providing the heating fluid (8) is below a predetermined temperature for a predetermined duration.

3. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12), said thermoelectric generating device comprising a third passage (15) arranged between said first passage (7) and said one side of the module (12), said third passage (15) being charged with fluidal heat mover (26) during a normal operation and having urgently cooling fluid (25) injected when the fluidal heat mover (26) reaches or exceeds a predetermined temperature.

4. A thermoelectric generating device as claimed in claim 3, wherein the fluidal heat mover (26) in the third passage (15) is discharged and the urgently cooling fluid (25) is injected into the third passage (15) when the fluidal heat mover (26) in the third passage (15) is at or above the predetermined temperature for a predetermined duration and wherein the urgently cooling fluid (25) in the third passage (15) is discharged and the fluidal heat mover (26) is injected into the third passage (15) when the urgently cooling fluid (25) having been injected is at or below a predetermined temperature for a predetermined duration.

5. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12), said thermoelectric generating device comprising a third passage (15) arranged between said first passage (7) and said one side of the module (12), said third passage (15) being charged with fluidal heat mover (26) during a normal operation and having urgently cooling fluid (25) injected when the thermoelectric element (1)(2) reaches or exceeds a predetermined temperature.

6. A thermoelectric generating device as claimed in claim 5, wherein the fluidal heat mover (26) in the third passage (15) is discharged and the urgently cooling fluid (25) is injected into the third passage (15) when the thermoelectric element (1)(2) is at or above the predetermined temperature for a predetermined duration and wherein the urgently cooling fluid (25) in the third passage (15) is discharged and the fluidal heat mover (26) is injected into the third passage (15) when the thermoelectric element (1)(2) is at or below the predetermined temperature for a predetermined duration.

7. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12), said thermoelectric generating device comprising a bypass passage (33) connected via valve means (31) to the first passage (7) upstream of the thermoelectric module (12).

8. A thermoelectric generating device as claimed in claim 7 further comprising
a temperature sensor (34) for detecting temperature of the thermoelectric element (1)(2) or temperature in the first passage (7) downstream of the valve means (31) and
a controller (35) which outputs changeover command (V11) to said valve means (31) so as to feed the heating fluid (8) to the bypass passage (33) when the temperature detected by said sensor (34) is above a predetermined value for a predetermined duration,
said controller (35) outputting changeover command (V11) to said valve means (31) so as to feed the heating fluid (8) to the first passage (7) when the temperature detected by the sensor (34) is lower than a predetermined value for a predetermined duration.

9. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12),
said thermoelectric generating device comprising a bypass passage (33) with one end connected through first valve means (31) to said first passage (7) upstream of the module,
said bypass passage (33) having the other end connected via second valve means (36) to said first passage (7) downstream of the module (12).

10. A thermoelectric generating device as claimed in claim 9 further comprising
a temperature sensor (34) for detecting temperature of the thermoelectric element (1)(2) or temperature in the first passage (7) between the first and second valve means (31) (36) and
a controller (35) which outputs changeover command (V11) to said first valve means (31) for changeover thereof so as to feed the heating fluid (8) to the bypass passage (33), and outputs changeover command (V12) to said second valve means (36) for changeover thereof so as to feed the heating fluid (8) having been passed through the bypass passage (33) to the first passage (7) downstream of the module (12) when the temperature detected by the sensor (34) is above a predetermined value for a predetermined duration,
said controller (35) outputting changeover command (V11) to said first valve means (31) for changeover thereof so as to feed the heating fluid (8) to said first passage (7), and outputting changeover command (V12) to said second valve means (36) for changeover thereof so as to feed the heating fluid (8) having been passed through said first passage (7) to downstream of the second valve means (36) when the temperature detected by the sensor (34) is lower than a predetermined value for a predetermined duration.

11. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12),
said thermoelectric generating device comprising a bypass passage (33) connected via a first valve means (31) to the first passage (7) upstream of the module (12) and
a third passage (40) connected to said first passage (7) downstream of the first valve means (31) and upstream of the module (12) so as to feed urgently cooling fluid (39) to the first passage (7) via said second valve means (38).

12. A thermoelectric generating device as claimed in claim 11, wherein a downstream end of the bypass passage (33) is connected to the first passage (7) downstream of the module (12).

13. A thermoelectric generating device as claimed in claim 11 further comprising
a temperature sensor (34) for detecting temperature of the thermoelectric element (1)(2) or temperature in the first passage (7) and
a controller (35) which outputs changeover command (V11) to said first valve means (31) for changeover thereof so as to feed the heating fluid (8) to the bypass passage (33), and outputs changeover command (V13) to said second valve means (38) for changeover thereof so as to feed the urgently cooling fluid (39) having been passed through the third passage (40) to said first passage (7) when the temperature detected by the sensor (34) is above a predetermined value for a predetermined duration,
said controller (35) outputting changeover command (V11) to said first valve means (31) for changeover thereof so as to feed the heating fluid (8) to the first passage (7) and outputting changeover command (V13) to said second valve means (38) for changeover thereof so as to feed the heating fluid (8) having been passed through said first valve means (31) and through said first passage (7) to downstream of the second valve means (38) and so as not to feed the urgently cooling fluid (39) to the first passage (7) when the temperature detected by the sensor (34) is lower than a predetermined value for a predetermined duration.

14. A thermoelectric generating device as claimed in claim 12 further comprising
a temperature sensor (34) for detecting temperature of the thermoelectric element (1)(2) or temperature in the first passage (7) and
a controller (35) which outputs changeover command (V11) to said first valve means (31) for changeover thereof so as to feed the heating fluid (8) to the bypass passage (33), and outputs changeover command (V13) to said second valve means (38) for changeover thereof so as to feed the urgently cooling fluid (39) having been passed through the third passage (40) to said first passage (7) when the temperature detected by the sensor (34) is above a predetermined value for a predetermined duration,
said controller (35) outputting changeover command (V11) to said first valve means (31) for changeover thereof so as to feed the heating fluid (8) to the first passage (7) and outputting changeover command (V13) to said second valve means (38) for changeover thereof so as to feed the heating fluid (8) having been passed through said first valve means (31) and through said first passage (7) to downstream of the second valve means (38) and so as not to feed the urgently cooling fluid (39) to the first passage (7) when the temperature detected by the sensor (34) is lower than a predetermined value for a predetermined duration.

15. A thermoelectric generating device with a thermoelectric module (12) having p- and n-type thermoelectric elements (1)(2) electrically connected in series, a first passage (7) through which heating fluid (8) flows so as to heat one side of the module (12) and a second passage (10) through which cooling fluid (11) flows so as to cool the other side of the thermoelectric module (12), said thermoelectric generating device comprising a third passage (40) connected via valve means (41) to the first passage (7) upstream of the module (12) so as to feed the urgently cooling fluid (39) to the first passage (7).

16. A thermoelectric generating device as claimed in claim 15 further comprising
a temperature sensor (34) for detecting temperature of the thermoelectric element (1)(2) or temperature in the first passage (7) downstream of the valve means (41) and
a controller (35) which outputs changeover command (V14) to said valve means (41) for changeover thereof so as to feed the heating fluid (8) and urgently cooling fluid (39) to the first passage (7) when the temperature detected by the sensor (34) is above a predetermined value for a predetermined duration,
said controller (35) outputting changeover command (V14) to said valve means (41) for changeover thereof so as to feed the heating fluid (8) to the first passage (7) and so as not to feed the urgently cooling fluid (39) to the first passage (7) when the temperature detected by the sensor (34) is lower than a predetermined value for a predetermined duration.
